# EUROPEAN PATENT APPLICATION

(11) **EP 3 961 724 A1**
(43) Date of publication of application: **02.03.2022**
(21) Application number: 20796029.5
(22) Date of filing: 21.04.2020
(51) Int. Cl.: H01L 29/872, H01L 21/329

(54) **SEMICONDUCTOR DEVICE AND METHOD OF MANUFACTURING SEMICONDUCTOR DEVICE**

(30) Priority: 25.04.2019 JP 2019083508
(71) Applicant: Kyocera Corporation, Kyoto-shi, Kyoto 612-8501 (JP)
(72) Inventor: NAKAZATO, Yusuke, Kyoto-shi, Kyoto 612-8501 (JP); HIRAYAMA, Tomohisa, Kyoto-shi, Kyoto 612-8501 (JP)
(74) Representative: Viering, Jentschura & Partner mbB Patent- und Rechtsanwälte
(86) International application number: PCT/JP2020/017191
(87) International publication number: WO 2020/218294

(57) **Abstract**

In this semiconductor device 100, a trench 104 is formed on the upper surface of a n-type semiconductor layer 102 laminated on a semiconductor substrate 101, a Schottky junction with a metal 106 is formed on the upper surface of an n-type region 102A forming one side surface S3 of the trench, and a pn junction is formed on the upper surface of an n-type region 102 forming the other side surface S2 of the trench. The pn junction is formed by a junction between the n-type region and the p-type semiconductor layer 103A crystal-grown via epitaxial growth on the upper surface of the n-type region forming the other side surface.

## Description

### TECHNICAL FIELD

The present disclosure relates to a semiconductor device and a method of manufacturing a semiconductor device.

### BACKGROUND ART

Conventionally, as described in JP H11-8399A, in a known semiconductor device, a Schottky junction and a pn junction are formed in parallel on both sides of a trench. The pn junction is formed by introducing p-type impurities into an n-type semiconductor layer by an ion implantation method or the like.

### SUMMARY OF INVENTION

### TECHNICAL PROBLEM

Ion implantation technique may not be sufficiently established in the future for specific semiconductor materials like next-generation device materials (such as GaN and SiC). In cases where such materials are selected, it is difficult to form a p-type region accurately in a desired range using the ion implantation technique.

In a semiconductor device using a trench structure, to form a pn junction by introducing p-type impurities into an n-type semiconductor layer, the pn junction is formed at a position deeper than a surface of the n-type semiconductor layer. The pn junction is closer to a bottom of the trench. When a reverse voltage is applied, an electric field is concentrated on the pn junction and the bottom of the trench. Since portions on which the electric field is concentrated when the reverse voltage is applied are close, voltage endurance against reverse voltage application tends to decrease.

### SOLUTION TO PROBLEM

According to an aspect of the present disclosure, a semiconductor device includes:
a trench on an upper face of an n-type semiconductor layer layered on a semiconductor substrate;
a Schottky junction on an upper face of an n-type region located on a side of one lateral side of the trench; and
a pn junction on an upper face of an n-type region located on a side of another lateral side of the trench,
wherein the pn junction is a junction between:
   a p-type semiconductor layer having crystals grown by epitaxial growth on the upper face of the n-type region located on the side of the other lateral side; and
   the n-type region.

According to another aspect of the present disclosure, a method of manufacturing a semiconductor device includes:
a trench forming step of forming a trench on an upper face of an n-type semiconductor layer layered on a semiconductor substrate;
a Schottky junction forming step of forming a Schottky junction on an upper face of a portion which is an n-type region forming one lateral side of the trench; and
a pn junction forming step of forming a pn junction on an upper face of a portion which is an n-type region forming another lateral side of the trench,
wherein, in the pn junction forming step, crystals of a p-type semiconductor layer are grown by epitaxial growth on the upper face of the portion which is the n-type region forming the other lateral side.

### BRIEF DESCRIPTION OF DRAWINGS

FIG. 1 is a schematic cross-sectional view for explaining a first embodiment of the disclosure.
FIG. 2 is a schematic cross-sectional view for explaining the first embodiment and a second embodiment of the disclosure.
FIG. 3 is a schematic cross-sectional view for explaining the first and second embodiments of the disclosure.
FIG. 4 is a schematic cross-sectional view for explaining the first and second embodiments of the disclosure.
FIG. 5 is a schematic cross-sectional view for explaining the first and second embodiments of the disclosure.
FIG. 6 is a schematic cross-sectional view for explaining the first and second embodiments of the disclosure.
FIG. 7 is a schematic cross-sectional view for explaining the first and second embodiments of the disclosure.
FIG. 8 is a schematic cross-sectional view for explaining the first and second embodiments of the disclosure.
FIG. 9 is a schematic cross-sectional view for explaining a third embodiment of the disclosure.
FIG. 10 is a schematic cross-sectional view for explaining the third embodiment of the disclosure.
FIG. 11 is a schematic cross-sectional view for explaining the third embodiment of the disclosure.
FIG. 12 is a schematic cross-sectional view for explaining the third embodiment of the disclosure.
FIG. 13 is a schematic cross-sectional view for explaining the third embodiment of the disclosure.
FIG. 14 is a schematic cross-sectional view for explaining the third embodiment of the disclosure.
FIG. 15 is a schematic cross-sectional view for explaining the third embodiment of the disclosure.
FIG. 16 is a schematic cross-sectional view for explaining a fourth embodiment of the disclosure.
FIG. 17 is a schematic cross-sectional view for explaining the fourth embodiment of the disclosure.
FIG. 18 is a schematic cross-sectional view for explaining the fourth embodiment of the disclosure.
FIG. 19 is a schematic cross-sectional view for explaining the fourth embodiment of the disclosure.
FIG. 20 is a schematic cross-sectional view for explaining the fourth embodiment of the disclosure.
FIG. 21 is a schematic cross-sectional view for explaining the fourth embodiment of the disclosure.
FIG. 22 is a schematic cross-sectional view for explaining the fourth embodiment of the disclosure.
FIG. 23 is a schematic cross-sectional view for explaining a fifth embodiment of the disclosure.
FIG. 24 is a schematic cross-sectional view for explaining the fifth embodiment of the disclosure.
FIG. 25 is a schematic cross-sectional view for explaining the fifth embodiment of the disclosure.
FIG. 26 is a schematic cross-sectional view for explaining the fifth embodiment of the disclosure.
FIG. 27 is a schematic cross-sectional view for explaining the fifth embodiment of the disclosure.
FIG. 28 is a schematic cross-sectional view for explaining the fifth embodiment of the disclosure.
FIG. 29 is a schematic cross-sectional view for explaining the fifth embodiment of the disclosure.
FIG. 30 is a schematic cross-sectional view for explaining the fifth embodiment of the disclosure.
FIG. 31 is a schematic cross-sectional view for explaining another embodiment.
FIG. 32 is a schematic cross-sectional view for explaining another embodiment.
FIG. 33 is a graph showing change in a forward current density with respect to a forward voltage.
FIG. 34 is a graph showing change in a reverse current with respect to a reverse voltage.

### DESCRIPTION OF EMBODIMENTS

Embodiments of the present disclosure will be described below with reference to the figures.

### FIRST EMBODIMENT

First, a semiconductor device and a method of manufacturing the semiconductor device according to a first embodiment will be described.

### MANUFACTURE METHOD

The semiconductor device is manufactured as follows.

### STEP 1

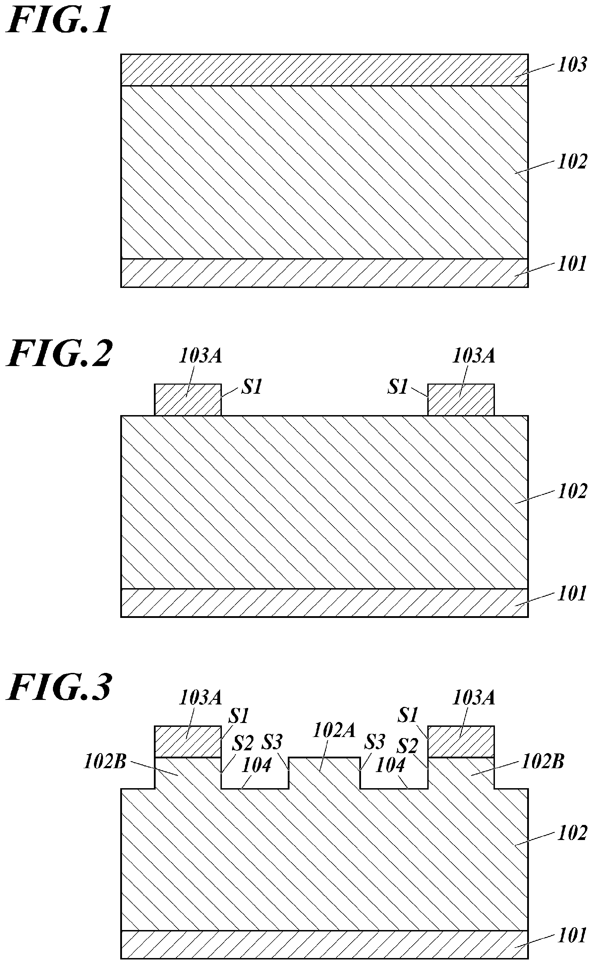

First, crystals of a p-type semiconductor layer 103 are grown by epitaxial growth on an upper face of an n-type semiconductor layer 102 layered on a semiconductor substrate 101 in FIG. 1. Thus, the p-type semiconductor layer 103 containing p-type impurities is layered by epitaxial growth. The semiconductor substrate 101 is n-type and has a higher concentration. The n-type semiconductor layer 102 has a lower concentration.

The p-type semiconductor layer 103 is formed at regions including a region to be a trench, a region to be a Schottky junction, and a region to be a pn junction.

### STEP 2

Next, as shown in FIG. 2, the p-type semiconductor layer 103 is removed by known selective etching at the region to be the trench and the region to be the Schottky junction. The p-type semiconductor layer 103A, which is a device element, remains.

As described above, a pn junction between the n-type semiconductor layer 102 and the p-type semiconductor layer 103A is formed (pn junction forming step).

A lateral side S1 of the p-type semiconductor layer 103A is an upper part of another lateral side (pn junction side) of the trench.

### STEP 3

Next, as shown in FIG. 3, trenches 104 are formed by digging the n-type semiconductor layer 102 by known selective etching. The n-type region 102A which is a convex between the trenches 104, 104 is a portion on which a Schottky junction is formed. A lateral side S2 of the n-type region 102B forming a pn junction with a lower face of the p-type semiconductor layer 103A is a lower part of the other lateral side (pn junction side) of the trench 104. A lateral side S3 of the n-type region 102A is one lateral side (Schottky junction side) of the trench 104.

Steps 2 to 3 constitute a trench forming step. Steps 1 to 2 constitute the pn junction forming step in which the pn junction is formed on an upper face of the portion (102B) which is the n-type region forming the other lateral side S2 of the trench 104.

### STEP 4

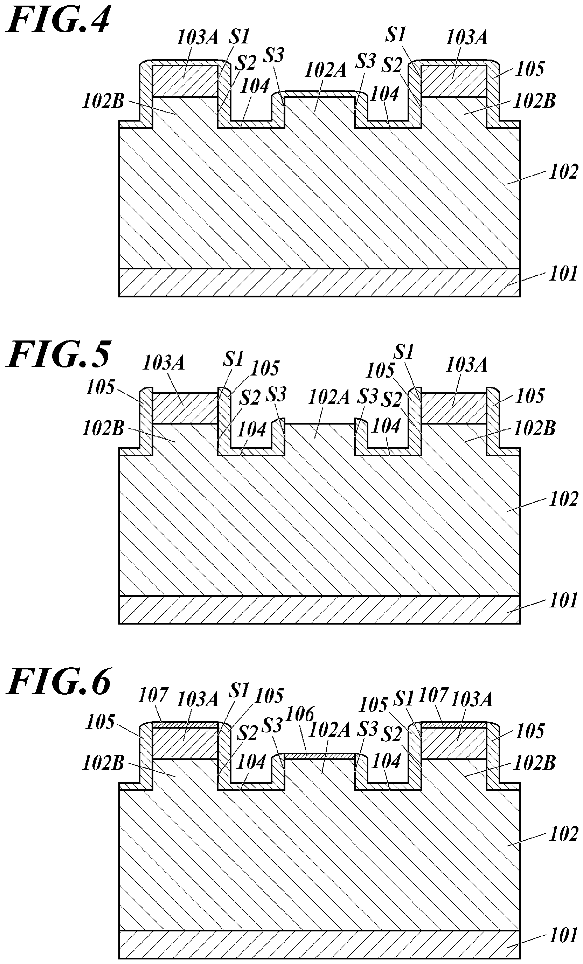

Next, as shown in FIG. 4, an insulating film 105 is formed by depositing an insulating material on an entire upper surface in a chemical vapor deposition method or the like.

### STEP 5

Next, the insulating film 105 is etched by a known selective etching as shown in FIG. 5. The upper face of the n-type region 102A and an upper face of the p-type semiconductor layer 103A are opened and exposed.

### STEP 6

Next, as shown in FIG. 6, a metal 106 is formed on the upper face of the n-type region 102A. The upper face of the n-type region 102A and the metal 106 form a Schottky junction. Thus, a Schottky junction forming step of forming the Schottky junction on the upper face of the portion (102A) which is the n-type region forming the one lateral side S3 of the trench 104 is performed.

As shown in FIG. 6, a metal 107 is formed on the upper face of the p-type semiconductor layer 103A. The upper face of the p-type semiconductor layer 103A and the metal 107 form an ohmic contact.

Formation of the Schottky junction and formation of the ohmic contact can be performed regardless of order.

Materials of the metals 106, 107 may be different or the same. The metals 106, 107 of the same materials may be formed at once.

### STEP 7

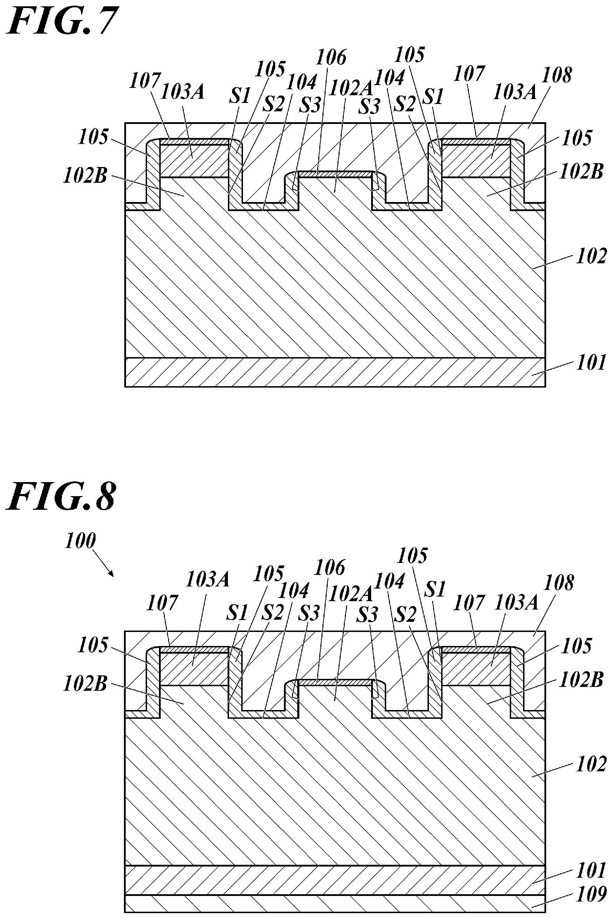

Next, as shown in FIG. 7, an anode electrode metal 108 connected to the metals 106, 107 is formed. Polysilicon may be embedded in the trench 104 before the anode electrode metal 108 is formed.

### STEP 8

Next, as shown in FIG. 8, a cathode electrode metal 109 is formed on a lower face of the semiconductor substrate 101.

The method of manufacturing the semiconductor device described above achieves the following advantageous effects.

The pn junction can be formed by growing crystals of the p-type semiconductor layer 103A by epitaxial growth. Even in a case where a semiconductor material (such as GaN and SiC) for which the ion implantation technique has not been sufficiently established is selected, it is easy to form the p-type semiconductor layer 103A accurately in a desired range.

A concentration of p-type impurities during epitaxial growth is controlled such that the concentration of p-type impurities in the p-type semiconductor layer 103A is large and the layer is thin. It shortens process time and reduces manufacture cost.

A concentration of impurities in a semiconductor layer formed by epitaxial growth is more likely to be uniform than that of a semiconductor layer formed by annealing after ion implantation.

### SEMICONDUCTOR DEVICE

For example, as shown in FIG. 8, a semiconductor device 100 that can be manufactured in the above manufacturing method includes the semiconductor substrate 101, the n-type semiconductor layer 102, the p-type semiconductor layer 103A, the trench 104, the insulating film 105, the metal 106 forming the Schottky junction, the metal 107 forming the ohmic contact, the anode electrode metal 108, and the cathode electrode metal 109.

The semiconductor device 100 is a diode in which the Schottky junction between the upper face of the n-type region 102A and the metal 106 and the pn junction between the n-type region 102B and the p-type semiconductor layer 103A are arranged in parallel between the anode electrode metal 108 and the cathode electrode metal 109. It is also called an MPS (Merged PiN Schottky) diode.

The semiconductor device 100 has a structure in which:
the trenches 104 are formed on the upper face of the n-type semiconductor layer 102 layered on the semiconductor substrate 101;
the Schottky junction is formed on the upper face of the n-type region 102A forming one lateral side S3 of the trench 104; and
the pn junction is formed on an upper face of the n-type region 102B forming the other lateral side S2 of the trench 104.

The pn junction is a junction between:
the p-type semiconductor layer 103A having crystals grown by epitaxial growth on the upper face of the n-type region 102B forming the other lateral side S2; and
the n-type region 102B.

The pn junction formed on the upper face of the n-type region 102B is located at the same height as the Schottky junction formed on the upper face of the n-type region 102A.

Regarding semiconductor materials, materials of the n-type semiconductor layer 102 and the p-type semiconductor layer 103A include GaN.

Alternatively, materials of the n-type semiconductor layer 102 and the p-type semiconductor layer 103A include one of SiC (silicon carbide), diamond, Ga2O3 (gallium oxide), and AlN (aluminum nitride).

The semiconductor device 100 described above achieves the following advantageous effects.

Since an electric field is concentrated on the insulating film 105 at a bottom of the trench 104 when a reverse voltage is applied, voltage endurance is high.

Since holes are injected from the p-type semiconductor layer 103A, resistance is low at the time of forward bias.

Since the p-type semiconductor layer 103A reduces a reverse leakage current, loss is smaller.

The pn junction between the p-type semiconductor layer 103A and the n-type region 102B is located above a bottom of the trench 104. The pn junction and the bottom of the trench (insulating film 105) are portions on which an electric field is concentrated when a reverse voltage is applied. A distance between the pn junction and the bottom of the trench increases by an amount they are separated in a vertical direction (layer thickness direction). It reduces electric field concentration and improves voltage endurance against application of a reverse voltage. A distance in the vertical direction (layer thickness direction) between the pn junction and the bottom of the trench can be easily controlled by changing a depth (etching depth in Step 3) of the bottom of the trench 104 with respect to the upper face of the n-type region 102B. Desired effect of improved voltage endurance can be easily achieved.

### SECOND EMBODIMENT

Next, a method of manufacturing a semiconductor device of a second embodiment will be described.

In the manufacture method of the embodiment, Steps 1 to 2 in the first embodiment are replaced with the methods described below. Except for that, the same steps as those shown in FIGS. 2 to 8 are carried out. A semiconductor device with the same structure is manufactured.

In the embodiment, a region to be a pn junction is selected in the pn junction forming step. Crystals of the p-type semiconductor layer 103A (FIG. 2) are grown by epitaxial growth. That is, crystals of the p-type semiconductor layer 103A are grown by epitaxial growth using a pattern mask which opens in regions for forming the p-type semiconductor layer 103A. Therefore, the state in FIG. 2 is achieved without Step 1.

As described above, use of selective epitaxial growth simplifies process and reduces manufacture cost.

### THIRD EMBODIMENT

Next, a semiconductor device and a method of manufacturing a semiconductor device according to a third embodiment will be described.

### MANUFACTURE METHOD

The semiconductor device is manufactured as follows.

### STEP B1

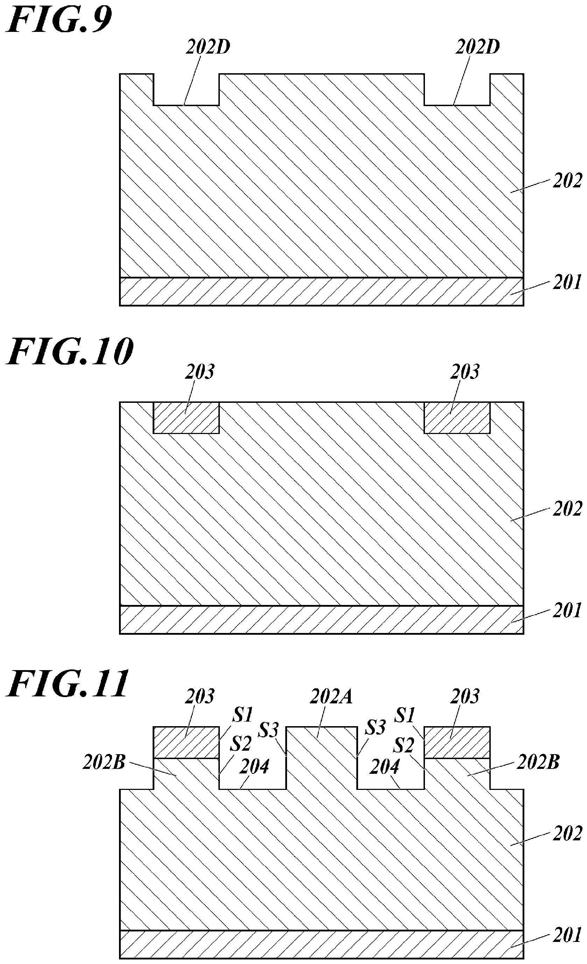

First, as shown in FIG. 9, a region to be a pn junction on an upper face of an n-type semiconductor layer 202 layered on a semiconductor substrate 201 is selected. The region is dug by known selective etching. Thus, a recess 202D is formed. The semiconductor substrate 201 is n-type and has a higher concentration. The n-type semiconductor layer 202 has a lower concentration.

### STEP B2

Next, the recess 202D is selected, and crystals of the p-type semiconductor layer 203 are grown by epitaxial growth (pn junction forming step). That is, the p-type semiconductor layer 203 containing P-type impurities is layered in the recess 202D by epitaxial growth using a pattern mask which opens above the recess 202D. The pattern mask is removed to obtain the structure in FIG. 10. After removing the pattern mask, smoothing may be performed. In the smoothing, surfaces are polished such that levels of an upper face of the n-type semiconductor layer 202 and an upper face of the p-type semiconductor layer 203 are matched.

### STEP B3

Next, as shown in FIG. 11, trenches 204 are formed by digging the n-type semiconductor layer by known selective etching (trench forming step). An n-type region 202A which is a convex between the trenches 204, 204A is a portion on which a Schottky junction is formed.

A lateral side S1 of the p-type semiconductor layer 203 is an upper part of another lateral side (pn junction side) of the trench. A lateral side S2 of the n-type region 202B forming a pn junction with a lower face of the p-type semiconductor layer 203 is a lower part of the other lateral side (pn junction side) of the trench 204. A lateral side S3 of the n-type region 202A is one lateral side (Schottky junction side) of the trench 204.

### STEP B4

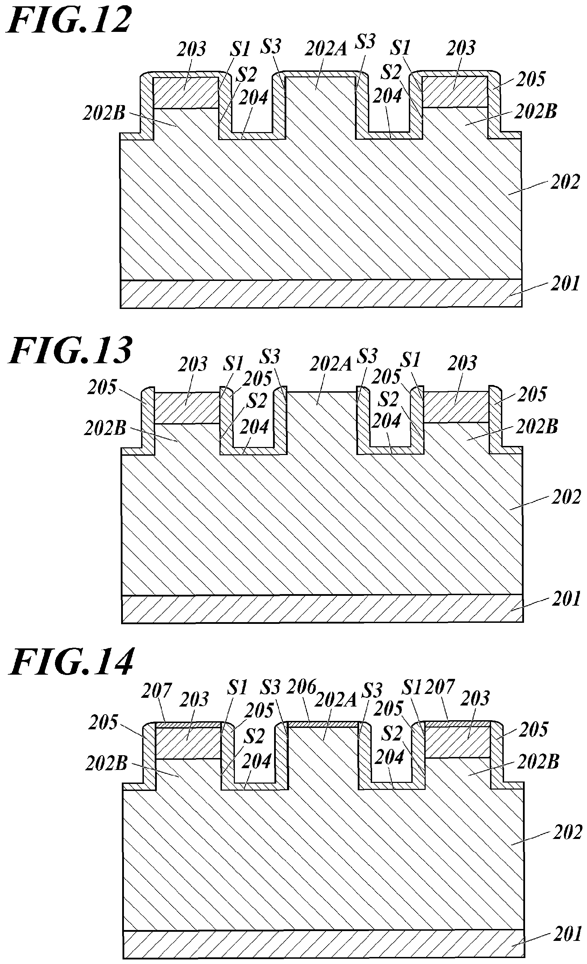

Next, as shown in FIG. 12, an insulating film 205 is formed by depositing an insulating material on an entire upper surface in a chemical vapor deposition method or the like.

### STEP B5

Next, the insulating film 205 is etched by known selective etching as shown in FIG. 13. The upper face of the n-type region 202A and an upper face of the p-type semiconductor layer 203 are opened and exposed.

### STEP B6

Next, as shown in FIG. 14, a metal 206 is formed on the upper face of the n-type region 202A. The upper face of the n-type region 202A and the metal 206 form a Schottky junction. Thus, a Schottky junction forming step of forming the Schottky junction on the upper face of the portion (202A) which is the n-type region forming one lateral side S3 of the trench 204 is performed.

As shown in FIG. 14, a metal 207 is formed on the upper face of the p-type semiconductor layer 203. The upper face of the p-type semiconductor layer 203 and the metal 207 form an ohmic contact.

Formation of the Schottky junction and formation of the ohmic contact can be performed regardless of order.

Materials of the metals 206, 207 may be different or the same. The metals 206, 207 of the same materials may be formed at once.

### STEP B7

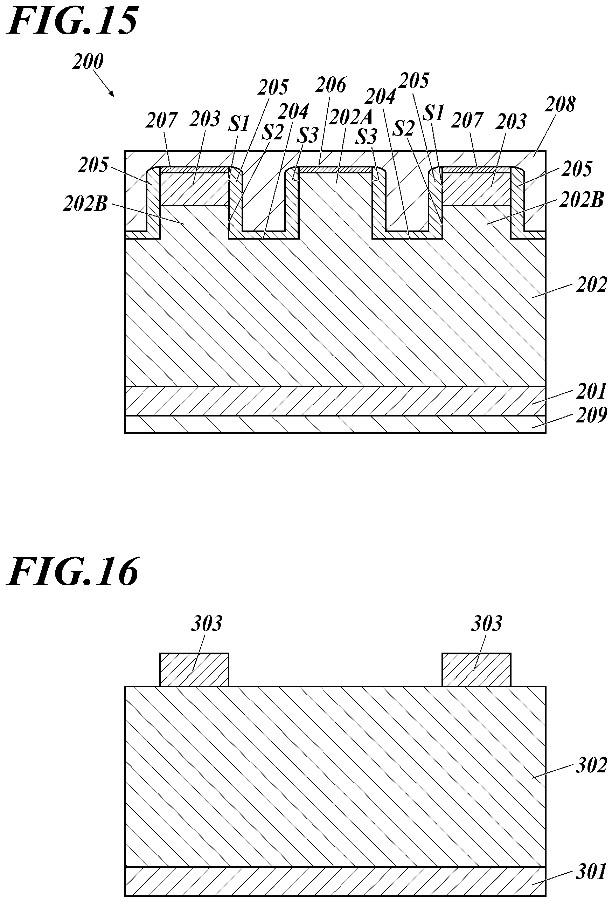

Next, as shown in FIG. 15, an anode electrode metal 208 connected to the metals 206, 207 is formed. Polysilicon may be embedded in the trench 204 before the anode electrode metal 208 is formed.

### STEP B8

On the other hand, as shown in FIG. 15, a cathode electrode metal 209 is formed on a lower face of the semiconductor substrate 201.

The method of manufacturing the semiconductor device described above achieves the following advantageous effects.

The pn junction can be formed by growing crystals of the p-type semiconductor layer 203 by epitaxial growth. Even in a case where a semiconductor material (such as GaN and SiC) for which the ion implantation technique has not been sufficiently established is selected, it is easy to form the p-type semiconductor layer 203 accurately in a desired range.

A concentration of p-type impurities during epitaxial growth is controlled such that the concentration of p-type impurities in the p-type semiconductor layer 203 is large and the layer is thin. It shortens process time and reduces manufacture cost.

The upper face of the n-type region 202A and the upper face of the p-type semiconductor layer 203 can be aligned at the same height. Difference between amounts of layered metals 206, 207, etc. due to different surface heights need not be considered. Burden in processes is reduced, and the yield is increased.

### SEMICONDUCTOR DEVICE

For example, as shown in FIG. 15, a semiconductor device 200 that can be manufactured by the above manufacture method includes the semiconductor substrate 201, the n-type semiconductor layer 202, the p-type semiconductor layer 203, the trench 204, the insulating film 205, the metal 206 forming the Schottky junction, the metal 207 forming the ohmic contact, the anode electrode metal 208, and the cathode electrode metal 209.

The semiconductor device 200 is a diode in which the Schottky junction between the upper face of the n-type region 202A and the metal 206 and the pn junction between the n-type region 202B and the p-type semiconductor layer 203 are arranged in parallel between the anode electrode metal 208 and the cathode electrode metal 209. It is also called an MPS (Merged PiN Schottky) diode.

The semiconductor device 200 has a structure in which:
the trenches 204 are formed on the upper face of the n-type semiconductor layer 202 layered on the semiconductor substrate 201;
the Schottky junction is formed on the upper face of the n-type region 202A forming one lateral side S3 of the trench 204; and
the pn junction is formed on an upper face of the n-type region 202B forming the other lateral side S2 of the trench 204.

The pn junction is a junction between:
the p-type semiconductor layer 203 having crystals grown by epitaxial growth on the upper face of the n-type region 202B forming the other lateral side S2; and
the n-type region 202B.

The pn junction formed on the upper face of the n-type region 202B is located at a lower level than the Schottky junction formed on the upper face of the n-type region 202A. The Schottky junction formed on the upper face of the n-type region 202A is located at the same height as the upper face of the p-type semiconductor layer 203.

Regarding the semiconductor material, materials of the n-type semiconductor layer 202 and the p-type semiconductor layer 203 include GaN.

Alternatively, materials of the n-type semiconductor layer 202 and the p-type semiconductor layer 203 include one of SiC, diamond, Ga2O3, and AlN.

The semiconductor device 200 described above achieves the following advantageous effects.

Since an electric field is concentrated on the insulating film 205 at a bottom of the trench 204 when a reverse voltage is applied, voltage endurance is high.

Since holes are injected from the p-type semiconductor layer 203, resistance is low at the time of forward bias.

Since the p-type semiconductor layer 203 reduces a reverse leakage current, loss is smaller.

The pn junction between the p-type semiconductor layer 203 and the n-type region 202B is located above a bottom of the trench 204. The pn junction and the bottom of the trench (insulating film 205) are portions on which an electric field is concentrated when a reverse voltage is applied. A distance between the pn junction and the bottom of the trench increases by an amount they are separated in a vertical direction (layer thickness direction). It reduces electric field concentration and improves voltage endurance against application of a reverse voltage. A distance in the vertical direction (layer thickness direction) between the pn junction and the bottom of the trench can be easily controlled by changing a depth (difference between an etching depth in Step B3 and an etching depth in Step B1) of the bottom of the trench 204 with respect to the upper face of the n-type region 202B. Desired effect of improved voltage endurance can be easily achieved.

### FOURTH EMBODIMENT

Next, a semiconductor device and a method of manufacturing a semiconductor device according to a fourth embodiment will be described.

### MANUFACTURE METHOD

The semiconductor device is manufactured as follows.

### STEP C1

First, as shown in FIG. 16, a p-type semiconductor layer 303 is formed on an upper face of an n-type semiconductor layer 302 layered on a semiconductor substrate 301 (pn junction forming step). A method for forming the p-type semiconductor layer 303 is selective epitaxial growth as in the second embodiment. The semiconductor substrate 301 is n-type and has a higher concentration. The n-type semiconductor layer 302 has a lower concentration.

### STEP C2

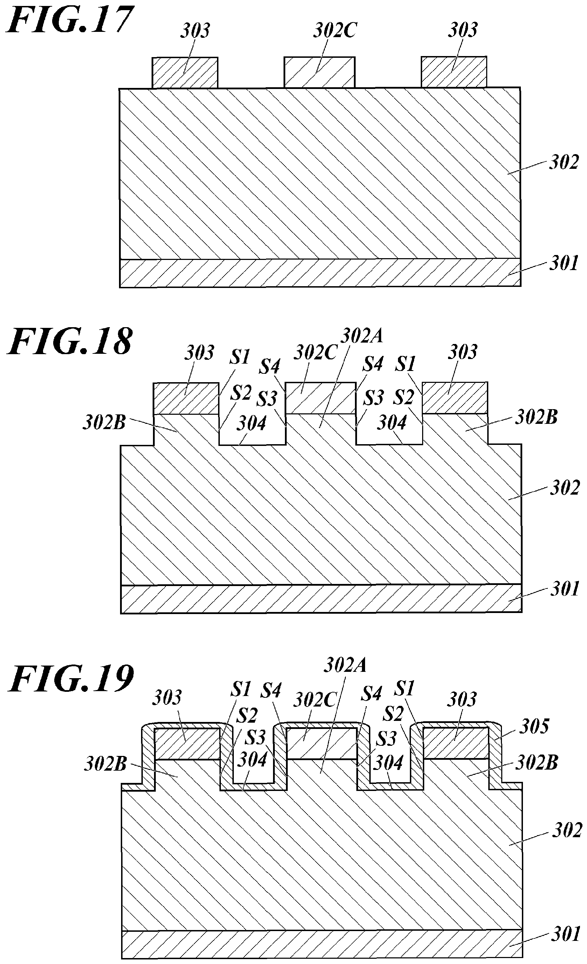

In the same manner of selective epitaxial growth, as shown in FIG. 17, a region to be a Schottky junction is selected, and crystals of an n-type semiconductor layer 302C are grown.

### STEP C3

Next, as shown in FIG. 18, the trenches 304 are formed by digging the n-type semiconductor layer 302 by known selective etching. Step C1, Step C2, and Step C3 constitute a trench forming step. The n-type region 302A between the trenches 304, 304 is a portion on which an n-type semiconductor layer 302C is layered.

A lateral side S1 of the p-type semiconductor layer 303 is an upper part of another lateral side (pn junction side) of the trench. A lateral side S2 of an n-type region 302B forming a pn junction with a lower face of the p-type semiconductor layer 303 is a lower part of the other lateral side (pn junction side) of the trench 304. A lateral side S3 of the n-type region 302A is a lower part of one lateral side (Schottky junction side) of the trench 304. A lateral side S4 of the n-type semiconductor layer 302C is an upper part of the one lateral side (Schottky junction side) of the trench 304.

### STEP C4

Next, as shown in FIG. 19, an insulating film 305 is formed by depositing an insulating material on an entire upper surface by a chemical vapor deposition method or the like.

### STEP C5

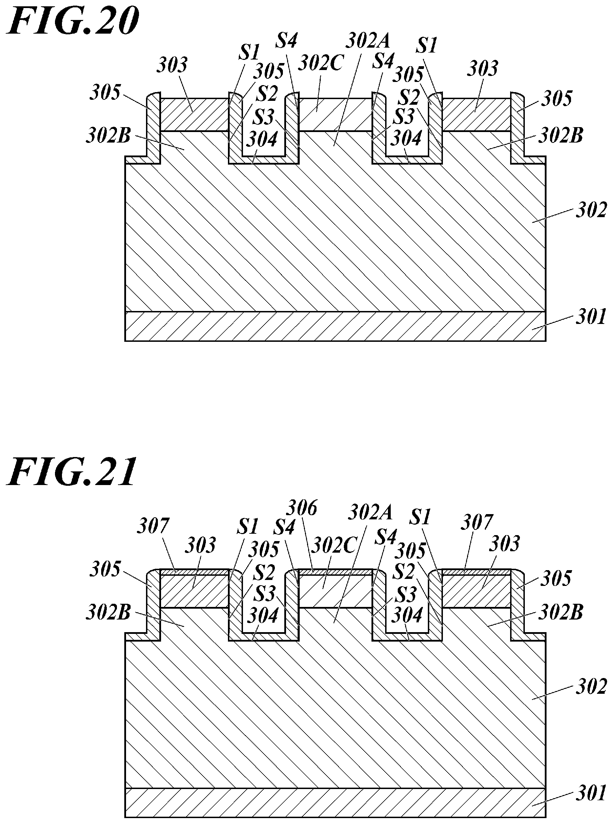

Next, the insulating film 305 is etched by known selective etching as shown in FIG. 20. An upper face of the n-type semiconductor layer 302C and an upper face of the p-type semiconductor layer 303 are opened and exposed.

### STEP C6

Next, as shown in FIG. 21, a metal 306 is formed on the upper face of the n-type semiconductor layer 302C. The upper face of the n-type semiconductor layer 302C and the metal 306 form a Schottky junction. Thus, a Schottky junction forming step of forming the Schottky junction on the upper face of the portion (302A, 302C) which is an n-type region forming one lateral side S3, S4 of the trench 304 is performed.

As shown in FIG. 21, a metal 307 is formed on the upper face of the p-type semiconductor layer 303. The upper face of the p-type semiconductor layer 303 and the metal 307 form an ohmic contact.

Formation of the Schottky junction and formation of the ohmic contact can be performed regardless of order.

Materials of the metals 306, 307 may be different or the same. The metals 306, 307 of the same materials may be formed at once.

### STEP C7

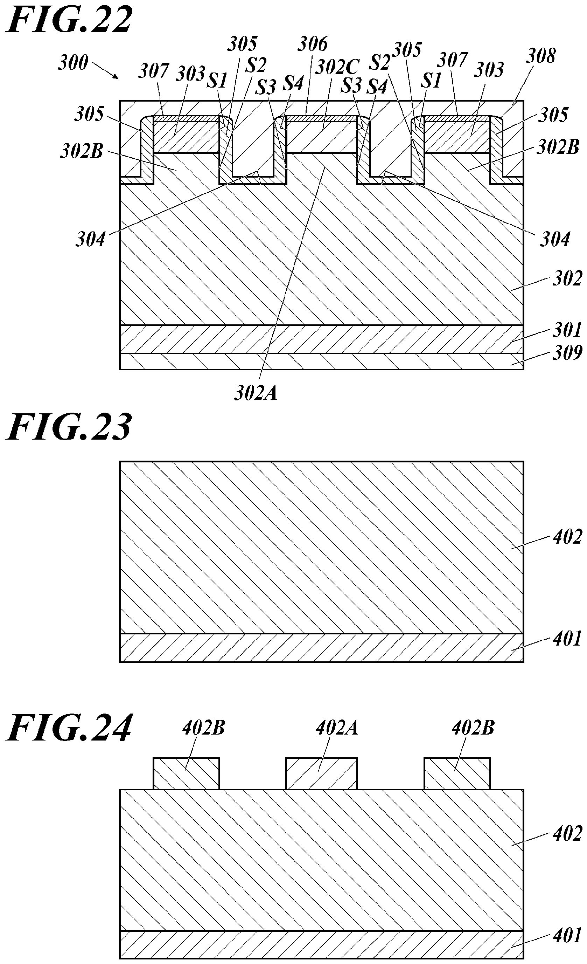

Next, as shown in FIG. 22, an anode electrode metal 308 connected to the metals 306, 307 is formed. Polysilicon may be embedded in the trench 304 before the anode electrode metal 308 is formed.

### STEP C8

On the other hand, as shown in FIG. 22, a cathode electrode metal 309 is formed on a lower face of the semiconductor substrate 301.

The method of manufacturing a semiconductor device described above achieves the following advantageous effects.

The pn junction can be formed by growing crystals of the p-type semiconductor layer 303 by epitaxial growth. Even in a case where a semiconductor material (such as GaN and SiC) for which the ion implantation technique has not been sufficiently established is selected, it is easy to form the p-type semiconductor layer 303 accurately in a desired range.

A concentration of p-type impurities during epitaxial growth is controlled such that the concentration of p-type impurities in the p-type semiconductor layer 303 is large and the layer is thin. It shortens process time and reduces manufacture cost.

The upper face of the n-type semiconductor layer 302C and the upper face of the p-type semiconductor layer 303 can be aligned at the same height. Difference between amounts of layered metals 306, 307, etc. due to different surface heights need not be considered. Burden in processes is reduced, and the yield is increased.

The number of processes in etching is less than that of the third embodiment by one. It reduces manufacture cost.

### SEMICONDUCTOR DEVICE

For example, as shown in FIG. 22, a semiconductor device 300 that can be manufactured by the above manufacturing method includes the semiconductor substrate 301, the n-type semiconductor layers 302, 302C, the p-type semiconductor layer 303, the trench 304, the insulating film 305, the metal 306 forming the Schottky junction, the metal 307 forming the ohmic contact, the anode electrode metal 308, and the cathode electrode metal 309.

The semiconductor device 300 is a diode in which the Schottky junction between the upper face of the n-type region 302C and the metal 306 and the pn junction between the n-type region 302B and the p-type semiconductor layer 303 are arranged in parallel between the anode electrode metal 308 and the cathode electrode metal 309. It is also called an MPS (Merged PiN Schottky) diode.

The semiconductor device 300 has a structure in which:
the trenches 304 are formed on the upper face of the n-type semiconductor layers 302, 302C layered on the semiconductor substrate 301;
the Schottky junction is formed on the upper face of the n-type region 302A, 302C forming the one lateral side S3, S4 of the trench 304; and
the pn junction is formed on an upper face of the n-type region 302B forming the other lateral side S2 of the trench 304.

The pn junction is a junction between:
the p-type semiconductor layer 303 having crystals grown by epitaxial growth on the upper face of the n-type region 302B forming the other lateral side S2; and
the n-type region 302B.

The pn junction formed on the upper face of the n-type region 302B is located at a lower level than the Schottky junction formed on the upper face of the n-type semiconductor layer 302C. The Schottky junction formed on the upper face of the n-type semiconductor layer 302C is located at the same height as the upper face of the p-type semiconductor layer 303.

Regarding the semiconductor material, materials of the n-type semiconductor layers 302, 302C and the p-type semiconductor layer 303 include GaN.

Alternatively, materials of the n-type semiconductor layers 302, 302C and the p-type semiconductor layer 303 include one of SiC, diamond, Ga2O3, and AlN.

The semiconductor device 300 described above achieves the following advantageous effects.

Since an electric field is concentrated on the insulating film 305 at a bottom of the trench 304 when a reverse voltage is applied, voltage endurance is high.

Since holes are injected from the p-type semiconductor layer 303, resistance is low at the time of forward bias.

Since the p-type semiconductor layer 303 reduces a reverse leakage current, loss is smaller.

The pn junction between the p-type semiconductor layer 303 and the n-type region 302B is located above a bottom of the trench 304. The pn junction and the bottom of the trench (insulating film 305) are portions on which an electric field is concentrated when a reverse voltage is applied. A distance between the pn junction and the bottom of the trench increases by an amount they are separated in a vertical direction (layer thickness direction). It reduces electric field concentration and improves voltage endurance against application of a reverse voltage. A distance in the vertical direction (layer thickness direction) between the pn junction and the bottom of the trench can be easily controlled by changing a depth (etching depth in step C3) of the bottom of the trench 304 with respect to the upper face of the n-type region 302B. Desired effect of improved voltage endurance can be easily achieved.

### FIFTH EMBODIMENT

Next, a semiconductor device and a method of manufacturing a semiconductor device according to a fifth embodiment will be described.

### MANUFACTURE METHOD

The semiconductor device is manufactured as follows.

### STEP D1

First, as shown in FIG. 24, n-type semiconductor layers 402A, 402B are formed on an upper face of an n-type semiconductor layer 402 layered on a semiconductor substrate 401 shown in FIG. 23. That is, a region to be a pn junction is selected, and crystals of the n-type semiconductor layer 402B are grown by epitaxial growth. At the same time, a region to be a Schottky junction is selected, and crystals of the n-type semiconductor layer 402A are grown by epitaxial growth. The semiconductor substrate 401 is n-type and has a higher concentration. The n-type semiconductor layer 402 has a lower concentration.

### STEP D2

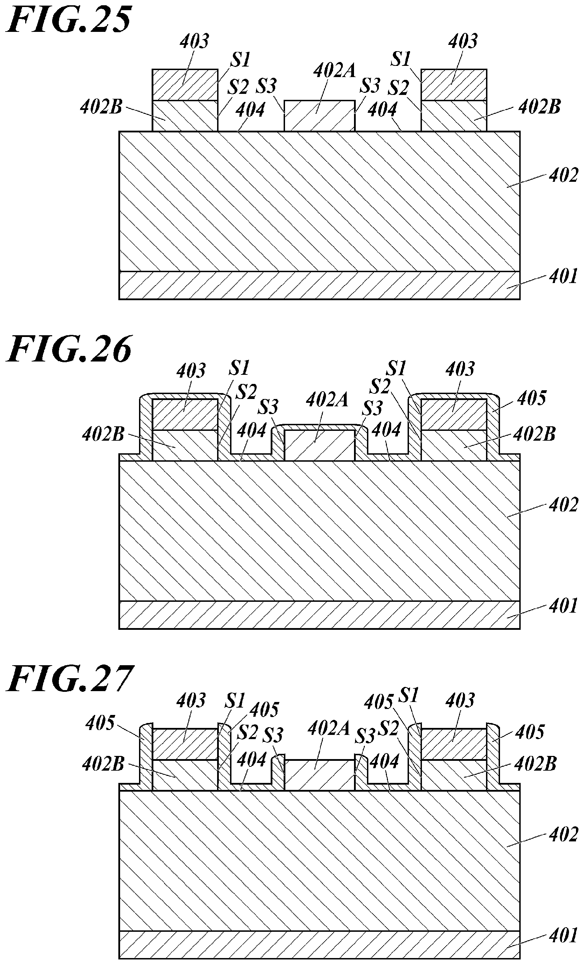

In the same manner of selective epitaxial growth, as shown in FIG. 25, an upper face of the n-type semiconductor layer 402B is selected, and crystals of a p-type semiconductor layer 403 are grown (pn junction forming step) .

Steps D1 to D2 constitute a trench forming step of forming a trench 404. A height of the n-type semiconductor layer 402A may be adjusted to match a height of the p-type semiconductor layer 403 by layering an n-type semiconductor layer also on an upper face of the n-type semiconductor layer 402A by epitaxial growth.

The n-type semiconductor layer 402A which is a convex between the trenches 404, 404 is a portion on which a Schottky junction is formed.

A lateral side S1 of the p-type semiconductor layer 403 is an upper part of another lateral side (pn junction side) of the trench 404. A lateral side S2 of the n-type semiconductor layer 402B forming a pn junction with a lower face of the p-type semiconductor layer 403 is a lower part of the other lateral side (pn junction side) of the trench 404. A lateral side S3 of the n-type semiconductor layer 402A is one lateral side (Schottky junction side) of the trench 404.

### STEP D3

Next, as shown in FIG. 26, an insulating film 405 is formed by depositing an insulating material on an entire upper surface by a chemical vapor deposition method or the like.

### STEP D4

Next, the insulating film 405 is etched by known selective etching as shown in FIG. 27. The upper face of the n-type semiconductor layer 402A and an upper face of the p-type semiconductor layer 403 are opened and exposed.

### STEP D5

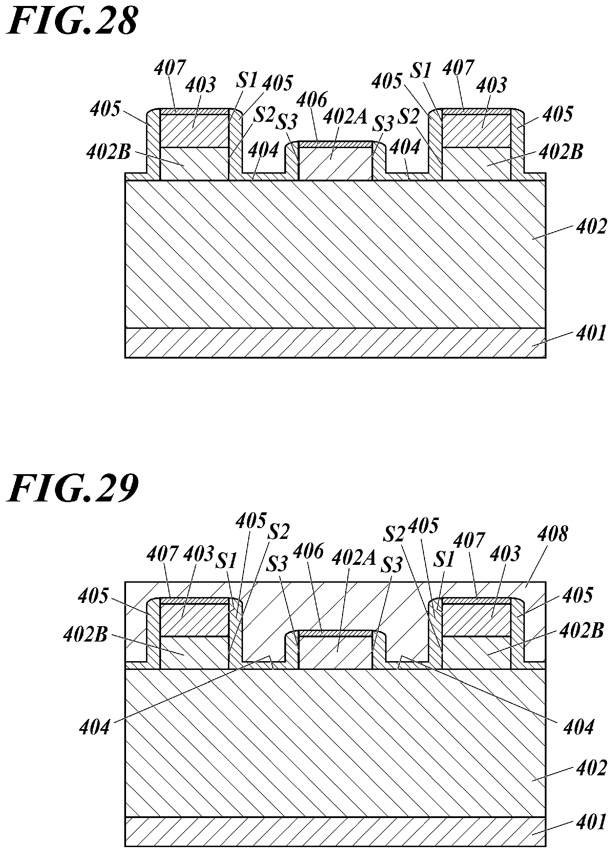

Next, as shown in FIG. 28, a metal 406 is formed on the upper face of the n-type semiconductor layer 402A. The upper face of the n-type semiconductor layer 402A and the metal 406 form a Schottky junction. Thus, a Schottky junction forming step of forming the Schottky junction on the upper face of the portion (402A) which is the n-type region forming one lateral side S3 of the trench 404 is performed.

As shown in FIG. 28, a metal 407 is formed on the upper face of the p-type semiconductor layer 403. The upper face of the p-type semiconductor layer 403 and the metal 407 form an ohmic contact.

Formation of the Schottky junction and formation of the ohmic contact can be performed regardless of order.

Materials of the metals 406, 407 may be different or the same. The metals 406, 407 of the same materials may be formed at once.

### STEP D6

Next, as shown in FIG. 29, an anode electrode metal 408 connected to the metals 406, 407 is formed. Polysilicon may be embedded in the trench 404 before the anode electrode metal 408 is formed.

### STEP D7

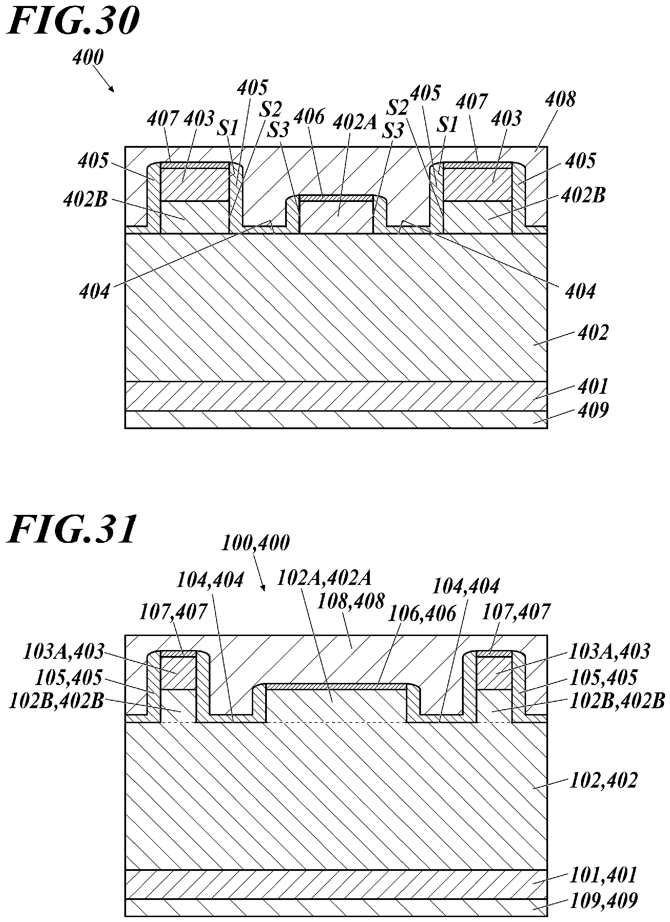

On the other hand, as shown in FIG. 30, a cathode electrode metal 409 is formed on a lower face of the semiconductor substrate 401.

The method of manufacturing the semiconductor device described above achieves the following advantageous effects.

The pn junction can be formed by growing crystals of the p-type semiconductor layer 403 by epitaxial growth. Even in a case where a semiconductor material (such as GaN and SiC) for which the ion implantation technique has not been sufficiently established is selected, it is easy to form the p-type semiconductor layer 403 accurately in a desired range.

A concentration of p-type impurities during epitaxial growth is controlled such that the concentration of p-type impurities in the p-type semiconductor layer 403 is large and the layer is thin. It shortens process time and reduces manufacture cost.

Since etching is not performed for the semiconductor layers 402, 402A, 402B, 403, less damage remains at interfaces with the insulating film 405. It prevents leakage.

### SEMICONDUCTOR DEVICE

For example, as shown in FIG. 30, a semiconductor device 400 that can be manufactured by the above manufacturing method includes the semiconductor substrate 401, the n-type semiconductor layers 402, 402A, 402B, the p-type semiconductor layer 403, the trench 404, the insulating film 405, the metal 406 forming the Schottky junction, the metal 407 forming the ohmic contact, the anode electrode metal 408, and the cathode electrode metal 409.

The semiconductor device 400 is a diode in which the Schottky junction between the upper face of the n-type region 402A and the metal 406 and the pn junction between the n-type region 402B and the p-type semiconductor layer 403 are arranged in parallel between the anode electrode metal 408 and the cathode electrode metal 409. It is also called an MPS (Merged PiN Schottky) diode.

The semiconductor device 400 has a structure in which:
the trenches 404 are formed on the upper face of the n-type semiconductor layers 402, 402A, 402B layered on the semiconductor substrate 401;
the Schottky junction is formed on the upper face of the n-type region 402A forming the one lateral side S3 of the trench 404; and
the pn junction is formed on the upper face of the n-type semiconductor layer 402B forming the other lateral side S2 of the trench 404.

The n-type semiconductor layers 402, 402A, 402B include the n-type semiconductor layers 402A, 402B in an upper part. Crystals of the n-type semiconductor layers 402A, 402B are grown by selective epitaxial growth.

The n-type semiconductor layers 402A, 402B related to the selective epitaxial growth form:
the n-type region forming the one lateral side S3; and
the n-type region forming the other lateral side S2.

The pn junction is a junction between:
the p-type semiconductor layer 403 having crystals grown by epitaxial growth on the upper face of the n-type semiconductor layer 402B forming the other lateral side S2; and
the n-type semiconductor layer 402B.

The pn junction formed on the upper face of the n-type semiconductor layer 402B is located at the same height as the Schottky junction formed on the upper face of the n-type semiconductor layer 402A.

Regarding the semiconductor material, materials of the n-type semiconductor layers 402, 402A, 402B and the p-type semiconductor layer 403 include GaN.

Alternatively, materials of the n-type semiconductor layers 402, 402A, 402B and the p-type semiconductor layer 403 include one of SiC, diamond, Ga2O3, and AlN.

The semiconductor device 400 described above achieves the following advantageous effects.

Since an electric field is concentrated on the insulating film 405 at a bottom of the trench 404 when a reverse voltage is applied, voltage endurance is high.

Since holes are injected from the p-type semiconductor layer 403, resistance is low at the time of forward bias.

Since the p-type semiconductor layer 403 reduces a reverse leakage current, loss is smaller.

The pn junction between the p-type semiconductor layer 403 and the n-type region 402B is located above a bottom of the trench 404. The pn junction and the bottom of the trench (insulating film 405) are portions on which an electric field is concentrated when a reverse voltage is applied. A distance between the pn junction and the bottom of the trench increases by an amount they are separated in a vertical direction (layer thickness direction). It reduces electric field concentration and improves voltage endurance against application of a reverse voltage. A distance in the vertical direction (layer thickness direction) between the pn junction and the bottom of the trench can be easily controlled by changing a depth (stacking height in step D1) of the bottom of the trench 404 with respect to the upper face of the n-type region 402B. Desired effect of improved voltage endurance can be easily achieved.

### OTHER EMBODIMENTS AND COMPARISON OF CHARACTERISTICS

In the above first to fifth embodiments, a total area of the Schottky junction does not have to be the same as a total area of the pn junction (SBD rate 50% and PN rate 50%). A ratio of a total area of the Schottky junction to a total area of the pn junction can be set at any value.

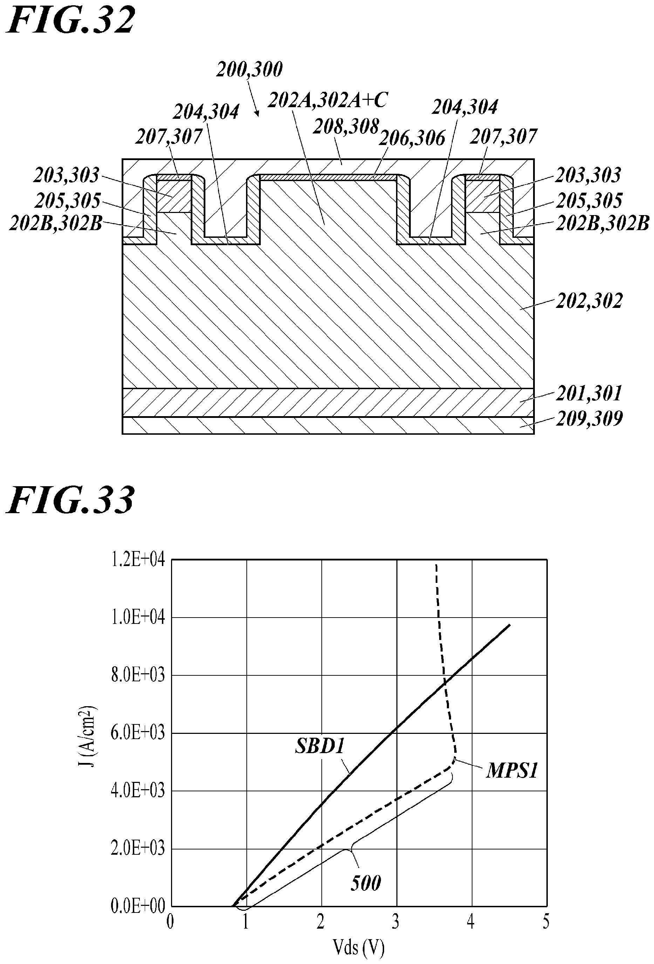

As shown in FIG. 31 or FIG. 32, a semiconductor device in which a total area of the Schottky junction is larger than a total area of the pn junction can be realized. Decrease in current density in a voltage range lower than an ON voltage of a PN diode can be suppressed by making a total area of the Schottky junction larger than a total area of the pn junction.

FIGS. 33 to 34 show voltage-current characteristics of:
an MPS having the trenches described above; and
a Schottky barrier diode (hereinafter referred to as "SBD") having trenches.

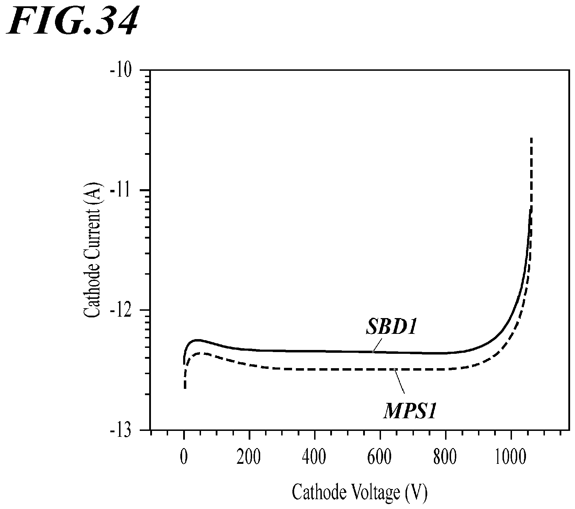

FIG. 33 is a graph showing change in a forward current density with respect to a forward voltage. FIG. 34 is a graph showing change in a reverse current with respect to a reverse voltage. The models compared are MPS1 and SBD1. MPS1 is an MPS with trenches and is a device having an SBD rate of 50% and a PN rate of 50%. SBD1 is the same as MPS1 except that it has an SBD rate of 100% and a PN rate of 0%. SBD1 has trenches similar to those of MPS1.

As shown in FIG. 33, SBD1 turns on at about 1V. The current changes linearly with respect to the voltage. In MPS1, a PN diode turns on at 3-4V. Further voltage rise is suppressed. This is because holes are injected from a p-type semiconductor layer (103A, 203, 303, 403), and resistance is significantly reduced. Therefore, a surge tolerance of MPS1 is larger than that of SBD1. As shown in FIG. 33, according to MPS1, a current density is lower than that of SBD1 in a voltage range 500 which is:
equal to or higher than the ON voltage of SBD; and
lower than the ON voltage of the PN diode.

This is because the PN diode occupies a part of the area and the PN diode is not turned on yet. Therefore, increasing an SBD rate increases a current density in the voltage range 500 (closer to the graph of SBD1).

As described above, a total area of the Schottky junction is made larger than a total area of the pn junction. Thereby, decrease in current density can be suppressed in a voltage range lower than the ON voltage of the PN diode.

On the other hand, as shown in FIG. 34, endurance of MPS1 is higher than that of SBD1. This is because an SBD ratio having a large reverse leakage current is reduced by providing a pn junction of a p-type semiconductor layer (103A, 203, 303, 403). The reverse leakage current is reduced. Therefore, loss is smaller in MPS1.

Embodiments of the present disclosure are described above. Embodiments are shown as examples, and various modifications are possible. The components can be omitted, replaced or changed within the scope of the claims of the disclosure.

### INDUSTRIAL APPLICABILITY

The present disclosure can be used in a semiconductor device and a method of manufacturing a semiconductor device.

### REFERENCE SIGNS LIST

- 100: semiconductor device

- 101: semiconductor substrate
- 102: n-type semiconductor layer
- 102A: n-type region
- 102B: n-type region
- 103: p-type semiconductor layer
- 103A: p-type semiconductor layer
- 104: trench
- 105: insulating film
- 106: metal
- 107: metal
- 108: anode electrode metal
- 109: cathode electrode metal
- 200: semiconductor device
- 201: semiconductor substrate
- 202: n-type semiconductor layer
- 202A: n-type region
- 202B: n-type region
- 202D: recess
- 203: p-type semiconductor layer
- 204: trench
- 205: insulating film
- 206: metal
- 207: metal
- 208: anode electrode metal
- 209: cathode electrode metal
- 300: semiconductor device
- 301: semiconductor substrate
- 302: n-type semiconductor layer
- 302A: n-type region
- 302B: n-type region
- 302C: n-type semiconductor layer
- 303: p-type semiconductor layer
- 304: trench
- 305: insulating film
- 306: metal
- 307: metal
- 308: anode electrode metal
- 309: cathode electrode metal
- 400: semiconductor device
- 401: semiconductor substrate
- 402: n-type semiconductor layer
- 402A: n-type semiconductor layer
- 402B: n-type semiconductor layer
- 403: p-type semiconductor layer
- 404: trench
- 405: insulating film
- 406: metal
- 407: metal
- 408: anode electrode metal
- 409: cathode electrode metal
- S1: lateral side of trench
- S2: lateral side of trench
- S3: lateral side of trench
- S4: lateral side of trench

## Claims

1. A semiconductor device, comprising:
a trench on an upper face of an n-type semiconductor layer layered on a semiconductor substrate;
a Schottky junction on an upper face of an n-type region located on a side of one lateral side of the trench; and
a pn junction on an upper face of an n-type region located on a side of another lateral side of the trench,
wherein the pn junction is a junction between:
a p-type semiconductor layer having crystals grown by epitaxial growth on the upper face of the n-type region located on the side of the other lateral side; and
the n-type region.

2. The semiconductor device according to claim 1, wherein the pn junction is located above a bottom of the trench.

3. The semiconductor device according to claim 1, wherein the pn junction is located at the same height as the Schottky junction.

4. The semiconductor device according to claim 1, wherein the Schottky junction is located at the same height as an upper face of the p-type semiconductor layer.

5. The semiconductor device according to any one of claims 1 to 4, wherein
the n-type semiconductor layer includes an n-type semiconductor layer obtained by growing crystals by selective epitaxial growth in an upper part, and
the n-type semiconductor layer obtained by the selective epitaxial growth forms:
the n-type region forming the one lateral side; and
the n-type region forming the other lateral side.

6. The semiconductor device according to any one of claims 1 to 5, wherein a total area of the Schottky junction is larger than a total area of the pn junction.

7. The semiconductor device according to any one of claims 1 to 6, wherein the n-type semiconductor layer and the p-type semiconductor layer contain GaN.

8. The semiconductor device according to any one of claims 1 to 6, wherein the n-type semiconductor layer and the p-type semiconductor layer contain one of SiC, diamond, Ga2O3, and AlN.

9. A method of manufacturing a semiconductor device, comprising:
a trench forming step of forming a trench on an upper face of an n-type semiconductor layer layered on a semiconductor substrate;
a Schottky junction forming step of forming a Schottky junction on an upper face of a portion which is an n-type region forming one lateral side of the trench; and
a pn junction forming step of forming a pn junction on an upper face of a portion which is an n-type region forming another lateral side of the trench,
wherein, in the pn junction forming step, crystals of a p-type semiconductor layer are grown by epitaxial growth on the upper face of the portion which is the n-type region forming the other lateral side.

10. The method of manufacturing the semiconductor device according to claim 9, wherein, in the pn junction forming step:
the crystals of the p-type semiconductor layer are grown by the epitaxial growth at regions including a region to be the trench, a region to be the Schottky junction, and a region to be the pn junction; and
then, the p-type semiconductor layer is removed at the region to be the trench and the region to be the Schottky junction.

11. The method of manufacturing the semiconductor device according to claim 9, wherein, in the pn junction forming step, a region to be the pn junction is selected, and the crystals of the p-type semiconductor layer are grown by the epitaxial growth.

12. The method of manufacturing the semiconductor device according to claim 9, wherein, in the pn junction forming step:
a recess is formed by:
selecting a region to be the pn junction on the upper face of the n-type semiconductor layer; and
digging the region by etching; and
then, the recess is selected and the crystals of the p-type semiconductor layer are grown by the epitaxial growth.

13. The method of manufacturing the semiconductor device according to claim 9, wherein, in the trench forming step;
a region to be the Schottky junction is selected, and crystals of the n-type semiconductor layer are grown by the epitaxial growth; and
then, a region to be the trench is dug by etching.

14. The method of manufacturing the semiconductor device according to claim 9, wherein, in the trench forming step, a region to be the pn junction and a region to be the Schottky junction are selected, and crystals of the n-type semiconductor layer are grown by the epitaxial growth.
